**Europäisches Patentamt**

**European Patent Office**

**Office européen des brevets**

(19)

(11) Veröffentlichungsnummer: **0 086 361**
**B1**

## EUROPÄISCHE PATENTSCHRIFT

(12)

(45) Veröffentlichungstag der Patentschrift:
26.10.88

(51) Int. Cl.⁴: **G 11 C 17/00, G 11 C 29/00**

(21) Anmeldenummer: **83100648.1**

(22) Anmeldetag: **25.01.83**

(54) **Verfahren und Anordnung zur Funktionsprüfung eines elektrisch wortweise umprogrammierbaren Speichers.**

(30) Priorität: **16.02.82 DE 3205473**

(43) Veröffentlichungstag der Anmeldung:
**24.08.83 Patentblatt 83/34**

(45) Bekanntmachung des Hinweises auf die Patenterteilung:
**26.10.88 Patentblatt 88/43**

(84) Benannte Vertragsstaaten:
**AT DE FR GB IT**

(56) Entgegenhaltungen:
**WO - A - 82/00896**

**IEEE TRANSACTIONS ON ELECTRON DEVICES, Band ED-24, Nr. 5, Mai 1977, Seiten 564-568, New York, US; F.L. SCHUERMEYER: "Test results on an MNOS memory array"**
**PATENTS ABSTRACTS OF JAPAN, Band 7, Nr. 198 (P-220)[1343], 2. September 1983**

(73) Patentinhaber: **Siemens Aktiengesellschaft Berlin und München, Wittelsbacherplatz 2, D-8000 München 2 (DE)**

(72) Erfinder: **Schrenk, Hartmut, Dr., Dipl.-Phys., Fasanenweg 22, D-8013 Haar (DE)**

## Beschreibung

Die Erfindung betrifft ein Verfahren zur Funktionsprüfung eines elektrisch wortweise umprogrammierbaren Speichers mit Speichertransistoren aufweisenden Speicherzellen sowie eine Anordnung zur Durchführung des Verfahrens.

Speicher dieser Art werden im allgemeinen als EEPROMs (Electrically erasable programmable read-only memories) bezeichnet und können – wie z.B. aus der DE-PS 2 445 137 (US-PS 4 087 795) oder Electronics, 28. Febr. 1980, Seiten 113 bis 117 bekannt – in Floating-Gate-Technik oder als Haftstellenspeicher wie z.B. die sogenannten MNOS-Speicher ausgeführt sein.

Diese Speicher haben den Nachteil vergleichsweise langer Umprogrammierzeit, die je nach Speichertyp zwischen 1 ms 1 s je Speicherwort liegt. Dieser Nachteil macht sich insbesondere beim Testen der EEPROM-Speicher bemerkbar, wenn zur Kontrolle der Funktion aller Speicherbits die Speicheradressen nacheinander gelöscht und geschrieben werden müssen. Beispielsweise erfordert ein 16-kBit-EEPROM mit 8-Bit-Organisation bei 10 ms Löschzeit und 10 ms Schreibzeit je Adresse, zum Testen aller 2000 Adressen theoretisch 40 s. Diese Testzeit ist jedoch unter Berücksichtigung der Kosten moderner Automatiktester untragbar. Um die Testzeit und damit die Testkosten abzusenken, gibt es verschiedene Möglichkeiten, die jedoch mit Nachteilen behaftet sind. So kann die Löschung der in einen Speicher eingeschriebenen alten Information für alle Speicheradressen gleichzeitig erfolgen. Deshalb ist bei zahlreichen EEPROMs der Betriebsmodus der Gesamtlöschung des Speichers eingebaut, mit dem die Löschzeit vergleichsweise kaum noch ins Gewicht fällt. Ein analoges gleichzeitiges Gesamtschreiben eines EEPROMs mit vorgegebenem Testmuster ist jedoch nicht ohne weiteres möglich. Bei einem Floating-Gate-Speicher, der mit Kanalinjektion beschrieben wird, verbietet sich dies z.B. aus Gründen des Stromverbrauchs und der Verlustleistung. Bei einem EEPROM, das mittels Tunneleffekt, also ohne nennenswerten Stromfluss betrieben wird, ist das gemeinsame Beschreiben zwar grundsätzlich möglich, erfordert aber einen tiefen Eingriff in die Dekoder- und Ansteuerlogik des Speichers. Das fehlerfreie Programmierverhalten von Einzeladressen ist zudem nicht überprüft.

Im montierten Zustand können die Tests zwar wortweise, aber gleichzeitig an einer grösseren Anzahl von Exemplaren durchgeführt und auf diese Weise Testzeit eingespart werden. Diese Methode ist jedoch aus praktischen Gründen für das Testen von Speichern, die sich noch auf der Halbleiterscheibe befinden, nicht durchführbar, da dann die einzelnen Speichersysteme nur über Messspitzen kontaktiert werden können, so dass man sich in vielen Fällen auf Teilmessungen und statistische Aussagen beschränken muss.

Aufgabe der Erfindung ist es, hier Abhilfe zu schaffen und ein Verfahren und eine Anordnung zur Funktionsprüfung von EEPROMs vorzusehen, bei dem die für die Funktionsprüfung aufzuwendende Zeit erheblich verringert ist.

Diese Aufgabe wird bei einem Verfahren der eingangs genannten Art erfindungsgemäss dadurch gelöst, dass für die Funktionsprüfung die durch die Einsatzspannungsdifferenz zwischen gelöschtem und geschriebenem Zustand gegebene Breite der Lesefenster der Speichertransistoren im Vergleich zum Normalbetrieb reduziert wird.

Beim Umprogrammieren eines EEPROMs im Normalbetrieb wird die Schwellenspannung der Transistoren der Speicherzellen beim Löschen bzw. Schreiben üblicherweise soweit in negative oder positive Richtung verschoben, dass zwischen dem gelöschten und geschriebenen Zustand unter allen Toleranzschwankungen von Fertigung, Spannungsversorgung oder Produktalterung ein Lesefenster ausreichender Breite mit einem Sicherheitsabstand gegenüber der vorgegebenen Lesespannung entsteht, wobei unter Lesefenster der Spannungsbereich zwischen der Einsatzspannung eines Speichertransistors im gelöschten und der Einsatzspannung eines Speichertransistors im geschriebenen Zustand und unter Lesespannung die an das Gate des Speichertransistors zum Lesen anzulegende Spannung verstanden wird. Erfindungsgemäss wird nun das Lesefenster beim Testbetrieb unter Verzicht auf Sicherheit gegen Datenverluste verkleinert und auf diese Weise Testzeit gespart.

Vorteilhafterweise wird die Breite des Lesefensters um mindestens 50%, insbesondere um mindestens 80%, reduziert.

Um die bei verkleinertem Lesefenster und festliegender Lesespannung bestehende Gefahr, dass die Lesespannung nicht mehr im Fensterintervall liegt und einzelne Speicherzellen daher als defekt gemeldet werden, obwohl sie unter Sollbedingungen die Spezifikation erfüllen würden, zu vermeiden, wird vorteilhafterweise die Lesefensterbreite durch eine Zeitregelung des Lösch- und Schreibablaufes reduziert.

Es liegt im Rahmen der Erfindung, dass die Ansteuerschaltung für Löschen und Schreiben der Speicherzellen des Speichers mit unterschiedlicher Lösch- bzw. Schreibdauer betrieben wird und dass das Ende der Lösch- bzw. Schreibdauer durch die Kontrolle des Erreichens eines vorgegebenen Lösch- bzw. Schreibzustandes mindestens einer Speicherzelle des Speichers festlegbar ist, dass das Erreichen des vorgegebenen Löschzustandes durch Vergleich der Schwellspannung des Speichertransistors mit einer vorgegebenen Löschkontrollspannung festgelegt wird, und dass das Erreichen des vorgegebenen Schreibzustandes durch Vergleich der Schwellspannung des Speichertransistors mit einer vorgegebenen Schreibkontrollspannung ermittelt wird.

Die Reduzierung des Lesefensters während der Funktionsprüfung wird vorteilhafterweise durch Veränderung der am Steuergate der Speichertransistoren anlegbaren Lösch- und Schreibkontrollspannungen eingestellt. Dies kann mittels einer auf dem Speicherchip integrierten Schaltungsanordnung für die Zeitregelung des Lösch- und Schreibablaufes erreicht werden, es ist aber auch möglich, die internen Gatespannungen der Speichertransistoren definiert mittels einer auf dem Speicherchip angeordneten integrierten Hilfsschaltung umzuschalten. Hierbei ist es von Vorteil, die Spannung am Steuergate der Speichertransistoren über ein Anschlusspad extern zu ändern.

Die Lösch- und Schreibkontrollspannungen werden vorteilhafterweise zusammen mit der Auslesespannung mit einem gemeinsamen Spannungsteiler erzeugt und durch Veränderung einer einzigen Oberspannung gesteuert.

Es liegt weiterhin im Rahmen der Erfindung, dass die Verschiebung der Schwellenspannung der Speichertransistoren beim Umprogrammieren in einer Richtung gleichzeitig für alle Speicheradressen und in der anderen Richtung zeitlich nacheinander, insbesondere wortweise, erfolgt, dass die Verschiebung der Schwellenspannung der Speichertransistoren beim Umprogrammieren für alle Speicheradressen gleichzeitig erfolgt, und dass die Verschiebung der Schwellenspannung der Speichertransistoren beim Löschen und Schreiben wortseriell erfolgt.

Eine Anordnung zur Durchführung des erfindungsgemässen Verfahren ist vorteilhafterweise so ausgeführt, dass eine Ansteuerschaltung vorgesehen ist, die für Löschen und Schreiben mit für jede Speicherzelle variabler Lösch- bzw. Schreibdauer arbeitet und die das Ende der Lösch- bzw. Schreibdauer durch Kontrolle des Erreichens eines vorgegebenen Lösch- bzw. Schreibzustandes mindestens einer Speicherzelle aus der zu löschenden bzw. zu schreibenden Speicherzelle festlegt.

Die Erfindung wird im folgenden anhand der Figuren näher erläutert. Es zeigen:

Fig. 1 ausschnittsweise das Schaltbild eines Ausführungsbeispiels zur Durchführung des erfindungsgemässen Verfahrens,

Fig. 2 den zeitlichen Verlauf der Schwellenspannung eines Speichertransistors sowie Lösch- und Schreibzeit bei breitem Lesefenster und

Fig. 3 den zeitlichen Verlauf der Schwellenspannung eines Speichertransistors sowie Lösch- und Schreibzeit bei schmalem Lesefenster.

In den Figuren sind gleiche Elemente mit gleichen Bezugszeichen versehen.

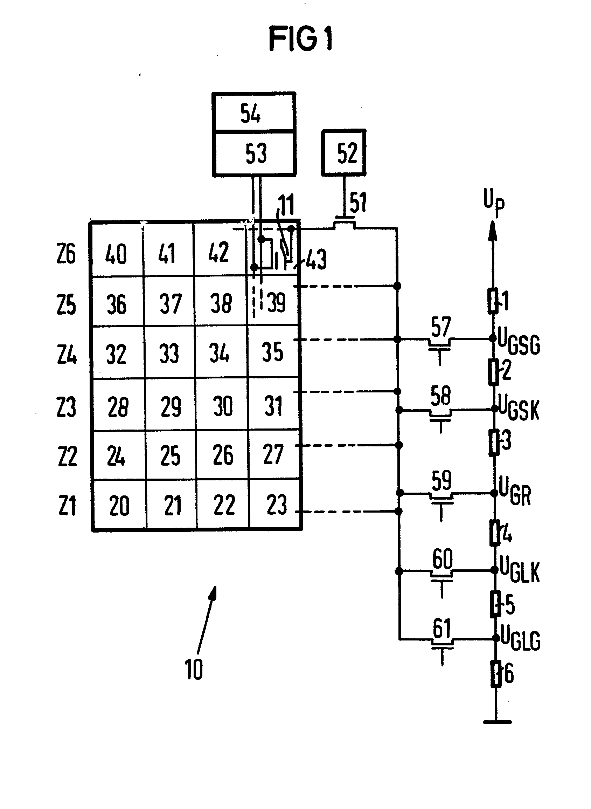

Das in der Fig. 1 gezeigte Schaltbild zeigt einen nichtflüchtigen umprogrammierbaren Speicher (EEPROM) 10 und aus Gründen der Übersichtlichkeit lediglich ausschnittsweise Teile der Steuer- und Kontrolllogik. Das EEPROM 10 besteht im gezeigten Fall aus 24 matrixförmig angeordneten und je einen Speichertransistor 11 aufweisenden Speicherzellen 20 bis 43, wobei jeweils vier Speicherzellen und damit vier Bit eine Speicherzelle bilden. Dieses Ausführungsbeispiel für das EEPROM 10 wurde aus Gründen der Übersichtlichkeit gewählt. Das erfindungsgemässe Verfahren ist aber insbesondere für Speicher mit grösseren Bitzahlen, z.B. 16-kBit-EEPROMs, geeignet. In der Fig. 1 ist aus Gründen der Übersichtlichkeit ferner nur ein Speichertransistor 11 dargestellt. Eine Speicherzelle kann auch – wie aus Electronics, 28. Febr. 1980, Seiten 113–117, bekannt – aus einem Speichertransistor 11 und einem in der Fig. 1 der besseren Übersicht wegen nicht dargestellten Auswahltransistor bestehen.

Erfindungsgemäss weisen die Speichertransistoren 11 der Speicherzellen des Speichers 10 während der Funktionskontrolle des Speichers 10 kleinere Lesefenster als im Normalbetrieb auf, wobei unter Lesefenster die (betragsmässige) Differenz von Einsatzspannung eines Speichertransistors 11 im programmierten Zustand und Einsatzspannung im unprogrammierten Zustand verstanden wird.

Die Breite der Lesefenster der Speichertransistoren der Zellen 20 bis 43 kann während der Funktionsüberprüfung beispielsweise über eine in der DE-OS 2 828 855 im einzelnen dargestellte Programmierzeitsteuerung verringert und kontrolliert werden, so dass während des Testens das Lesefenster nicht nur verschmälert wird, sondern die Umprogrammierung der Speicherzellen auch in der Weise kontrolliert wird, dass das Lesefenster die Lesespannung sicher einschliesst. Die in der zitierten Schrift beschriebene Zeitsteuerung arbeitet in der Weise, dass eine Ansteuerschaltung mit der Speichermatrix 10 zusammengeschaltet ist, und dass für jede Speicherzelle $Z_1$ bis $Z_6$ variable Lösch- und Schreibdauern vorgesehen sind, deren Ende durch das Erreichen eines vorgegebenen Lösch- bzw. Schreibzustandes einer oder mehrerer Speicherzellen aus der zu löschenden bzw. zu schreibenden Speicherzeile angezeigt wird, wobei der Lösch- bzw. Schreibzustand einer oder mehrerer Speicherzeilen der zu löschenden bzw. zu schreibenden Speicherzeile während der Lösch- bzw. Schreibdauer dieser Speicherzeile kontrolliert wird.

Dabei kann die Ansteuerung derart mit der Speichermatrix zusammengeschaltet sein, das zur Erreichung einer variablen Löschdauer einer Speicherzeile und zur Kontrolle des Löschzustandes einer oder mehrerer Speicherzellen der zu löschenden Zelle, die an den Speicherzellen anliegenden Löschspannungen in eine zeitliche Folge von Einzelimpulsen aufgeteilt werden, so dass in den Impulspausen jeweils ein Kontroll-Lesevorgang eingeschaltet wird. Es kann aber auch unter Umständen ein gleichzeitiges Löschen und Kontrolllesen vorgenommen werden.

Die Ansteuerung ist gemäss der DE-OS 2 828 855 ferner derart mit der Speichermatrix zusammengeschaltet, dass die Löschdauer einer Speicherzeile beendet ist, wenn alle Speicherzellen, an denen kontrollgelesen wird, eine Schwellspannung von $U_T$ aufweisen, wobei $U_T$ kleiner oder gleich $U_{GL}$ wenn $U_{GL}$ einen vorgegebenen Schwellwert der verwendeten Speicherzellen bedeutet.

Entsprechend gilt für die Ansteuerschaltung zur Erreichung einer variablen Schreibdauer, die also so ausgeführt ist, dass die Schreibdauer einer Speicherzeile beendet ist, wenn alle Speicherzellen, an denen kontrollgelesen wird, eine Schwellspannung $U_T$ grösser oder gleich $U_{GS}$ aufweisen, wobei $U_{GS}$ eine vorgebbare Schreibkontrollspannung ist.

Um einen sicheren Mindestabstand zwischen der zum Auslesen benötigten an das Gate des Speichertransistors 11 anzulegenden Gatespannung $U_{GR}$ zu garantieren, werden vorteilhafterweise die Gatespannungen, die als vorgegebene Schwellspannungswerte ($U_{GS}$ und $U_{GL}$) zum Kontrolllesen beim Programmieren und Löschen benötigt werden, sowie die Gatespannungen für das Auslesen der Speicherzellen ($U_{GR}$) aus ein- und demselben Spannungsteiler entnommen, so dass stets $U_{GL}$ kleiner als $U_{GR}$ und zugleich $U_{GR}$ kleiner als $U_{GS}$ gilt.

Bezüglich weiterer Details und insbesondere der schaltungstechnischen Realisierung der in der Fig. 1 aus Gründen der Übersichtlichkeit nicht dargestellten Source-Drain-Ansteuerungsschaltungen, der Auswertelogik, der Gateansteuerungsschaltung und der Steuerschaltung mit Impulsteil wird auf die ausführliche Darstellung in der DE-OS 2 828 855 verwiesen.

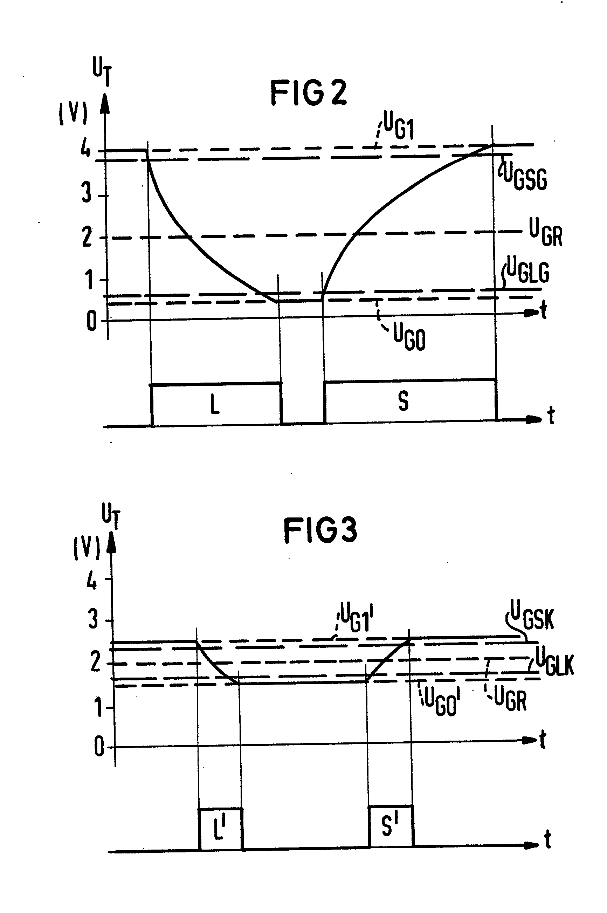

Die Programmierzeitsteuerung wird also so vorgenommen, dass beim Testen während des Umprogrammierablaufes die jeweilige Lage der Einsatzspannung (Schwellspannung) $U_T$ eines Speichertransistors 11 mit einer vorgegebenen Kontrolllesespannung $U_{GLK}$ bzw. einer vorgegebenen Kontrollschreibespannung $U_{GSK}$ verglichen wird, wie im oberen Teil der Fig. 3 dargestellt. Liegt die Schwellspannung $U_T$ oberhalb der Schwellspannung im programmierten Zustand $U'_{G1}$, so ist im Falle einer n-Kanal-MOS-Technik der Speichertransistor 11 sicher gesperrt. Für $U_T < U'_{G0}$ ($U'_{G0}$ = Einsatzspannung im unprogrammierten Zustand) ist analog die Speicherzelle sicher leitend. Am Wechsel zwischen leitendem und gesperrtem Zustand ist daher erkennbar, ob die Speicherzelle unter gegebenen Kontrollbedingungen einen gewünschten Programmierzustand erreicht hat. Durch Festlegung der Kontrollspannungen $U_{GSK}$ und $U_{GLK}$ werden damit die Spannungen $U'_{G1}$ bzw. $U'_{G0}$ und damit die Breite des Lesefensters gegenüber der Auslesespannung $U_{GR}$ festgelegt. Somit sind die Einsatzspannungen der Speicherzelle beim Löschen bzw. Schreiben definiert einstellbar. Die benötigten Löschdauern L' und Schreibdauern S' sind im unteren Teil der Fig. 3 dargestellt.

Während des Testens bzw. während der Funktionskontrolle wählt man nun erfindungsgemäss im Hinblick auf die Testzeit ein schmales Lesefenster, das im Falle eines Floating-Gate-Speichers wenige Zehntel Volt beträgt, d.h. das Lesefenster in Fig. 3 ($U'_{G1}$–$U'_{G0}$) beträgt einige Zehntel Volt. Für den Normalbetrieb wird im Hinblick auf Toleranzschwankungen von Fertigung, Spannungsversorgung oder Produktalterung ein Lesefenster von grösserer Breite mit einem grösseren Sicherheitsabstand gegenüber der vorgegebenen Lesespannung – wie z.B. in der Fig. 2 gezeigt – gewählt.

Das erfindungsgemässe Testverfahren ist besonders einfach anzuwenden, wenn der Speicher 10 auch in Normalbetrieb mit Zeitsteuerung der Programmierung arbeitet und zum Testen nur die Auswertgrenzen für das Erreichen eines Lösch- bzw. eines Schreibzustandes in Richtung auf die Auslesespannung hin verschoben werden müssen. Ein solches breiteres Lesefenster ($U_{G1}$–$U_{G0}$) wird gemäss Fig. 2 durch die Wahl von Schreibkontrollspannung $U_{GSG}$ und Lesekontrollspannung $U_{GLG}$ erreicht, wobei die Kontrollspannungen im Vergleich zu den Kontrollspannungen bei kleinem Lesefenster (Testbetrieb) $U_{GSK}$ und $U_{GLK}$ weiter von der Lesespannung $U_{GR}$ entfernt liegend gewählt werden. Mit dem grösseren Lesefenster vergrössert sich – wie in der Fig. 2 unten gezeigt – die Löschdauer L und die Schreibdauer S, die Datensicherheit ist jedoch erheblich verbessert.

Die Darstellung der Figuren 2 und 3 bezieht sich auf die Verwendung von mittels Kanalinjektion programmierbaren n-Kanal-MOS-Floating-Gate-Speichertransistoren, wie sie auch dem Ausführungsbeispiel DE-OS 2 828 855 zugrunde liegen. Bei Verwendung von n-Kanal-Transistoren, wie sie z.B. in Electronics, 28. Febr. 1980, Seiten 113 bis 117, beschrieben werden, wird die Schwellenspannung $U_{G1}$ durch den gelöschten und die Schwellenspannung $U_{G0}$ durch den geschriebenen Zustand gekennzeichnet.

Durch die Zeitsteuerung wird bei Normalbetrieb im Mittel bereits eine Programmierzeitverkürzung gegenüber dem Fall fester Lösch- bzw. Schreibzeiten erreicht. Eine Verringerung des Lesefensters im Testbetrieb auf z.B. 10% der Fensterbreite im Normalbetrieb verkürzt darüberhinaus wegen des asymptotischen Verlaufes der Schwellenspannungen gegen die Lösch- bzw. Schreibdauer die Programmierzeiten beim Testen auf weniger als 10% der Normalwerte, beispielsweise von 10 ms auf 1 ms pro Zeile Z1 bzw. pro Wort.

Bei Verwendung einer Programmierzeitsteuerung werden die Lesekontrollspannungen und die Schreibkontrollspannungen und die Lesespannung $U_{GR}$ vorteilhafterweise über einen gemeinsamen Spannungsteiler erzeugt, der die Reihenfolge der Spannungen unverändert festlegt. Dies gilt insbesondere bei der Verwendung einer Programmierzeitsteuerung sowohl für den Normal- als auch für den Testbetrieb.

Ein entsprechender Spannungsteiler, der aus einer Reihenschaltung der Widerstände 1, 2, 3, 4, 5 und 6 besteht, ist in der Fig. 1 dargestellt. Der Anschluss des Widerstandes 1, der nicht mit dem Widerstand 2 verbunden ist, ist an eine Versorgungsspannung $U_P$ angeschlossen, welche grösser ist als die Spannung $U_{GSG}$. Der Anschluss des Widerstandes 6, der nicht mit dem Widerstand 5 verbunden ist, ist geerdet. Zwischen den Widerständen 1 und 2 liegt dann die Kontrollschreibspannung $U_{GSG}$ zur Erzeugung eines grossen Lesefensters (Normalbetrieb), zwischen den Widerständen 2 und 3 die Schreibkontrollspannung ($U_{GSK}$) zum Erzeugen eines kleinen Lesefensters (Testbetrieb), zwischen den Widerständen 3 und 4 die eigentliche Lesespannung $U_{FR}$, zwischen den Widerständen 4 und 5 die Lesekontrollspannung $U_{GLK}$ zur Erzeugung eines kleinen Lesefensters (Testbetrieb) und zwischen den Widerständen 5 und 6 die Lesekontrollspannung $U_{GLG}$ zur Erzeugung eines breiten Lesefensters (Normalbetrieb).

Die Kontrollspannungen $U_{GSG}$ und $U_{GLG}$ und die Lesespannung $U_{GR}$ können dann über die Transfergates 57, 61, 59 und ein weiteres über den Zeilendecodierer der Gate-Ansteuer-Schaltung 52 zu steuerndes Transfergate 51 während des Normalbetriebes das Gate eines Speichertransistors 11, der dann ein breites Lesefenster aufweisen soll, beaufschlagen. Während des Testbetriebes werden die Gateelektroden der Speichertransistoren über die Transfergates 58, 60 und 59 und ein in der Figur aus Gründen der Übersichtlichkeit nicht dargestelltes, dem Transfergate 51 entsprechendes, weiteres Transfergate mit den Spannungen $U_{GSK}$, $U_{GLK}$ und $U_{GR}$ beaufschlagt und somit mit schmalen Lesefenstern versehen. Die Ansteuerung der Transfergates 51, 57, 58, 59, 60 und 61 erfolgt mittels einer Gate-Ansteuerungsschaltung 52, die der in der DE-OS 2 828 855 beschriebenen Gate-Ansteuerungsschaltung entsprechend ausführbar ist.

Die mit den Sourceanschlüssen und den Drainanschlüssen der Speichertransistoren 11 verbundene Auswertlogik 53 und die Source- und Drainansteuerung 54 kann ebenfalls entsprechend der in der DE-OS 2 828 855 beschriebenen Auswertlogik und Source- und Drainansteuerung ausgeführt sein. Für Testbetrieb und Normalbetrieb ist jeweils eine eigene Auswertlogik vorzusehen.

Das erfindungsgemässe Verfahren der Programmierzeitregelung während der Funktionsüberprüfung ist aber auch auf jeden anderen EEPROM-Speicher anwendbar, der die notwendige Steuerlogik zur Zeitregelung nicht selber enthält. Als einziger Testzusatz innerhalb des EEPROMs muss in der Regel nur die Möglichkeit vorgesehen sein, die Auslesespannung $U_{GR}$ am Steuergate 11 der Speichertransistoren der Speicherzellen extern zu beeinflussen, d.h. analog zu verändern. Dies kann z.B. dadurch erreicht werden, dass der Speicher ein Anschlussfeld (Pad), durch das die Spannung am Steuergate beeinflussbar ist, aufweist. Der in der DE-OS 2 828 855 im einzelnen beschriebene Impulsverlauf von Programmier- und Kontrollesespannung zur Realisierung der Programmierzeitregelung kann dann während der Bausteinprüfung problemlos durch die Testerlogik extern nachvollzogen werden.

Es ist auch möglich, bei integrierten Speicherschaltungen eine Hilfsschaltung vorzusehen, die im Testbetrieb die internen Gatespannungen definiert umschaltet und somit auch ohne integrierte Zeitsteuerlogik zusammen mit einer äusseren Schaltung oder einem Testgerät eine Zeitsteuerung des Programmierablaufs zulässt.

Die Anordnungen zum Erreichen verringerter Lesefensterbreiten während des Testbetriebes können also entweder im Speicherbaustein selber angeordnet sein, oder aber es ist möglich, diese Anordnungen extern vorzusehen und somit z.B. handelsübliche EEPROM-Speicher, bei denen die Gateanschlüsse der Speichertransistoren zugänglich sind, erfindungsgemäss zu betreiben.

Vorteilhafterweise wird beim erfindungsgemässen Verfahren die Lesefensterbreite während der Funktionsüberprüfung der Speicherzellen um mindestens 50%, insbesondere um mindestens 80% der Fensterbreite im Normalbetrieb verringert. Vorteilhaft ist eine Reduzierung auf 5 bis 50% der Fensterbreite im Normalbetrieb, bei geeigneter Auslegung der Speicherzelle und bei geeignetem Stabilisierungsaufwand für die Stabilisierung der Betriebsspannung ist aber auch eine Reduzierung auf weniger als 5% der Normalfensterbreite möglich.

Die Erfindung kann sowohl bei EEPROMs, die Floating-Gate-Speicherzellen verwenden, als auch bei anderen EEPROMs, beispielsweise MMOS-Speicherzellen verwendenden, angewendet werden.

**Patentansprüche**

1. Verfahren zur Funktionsprüfung eines elektrisch wortweise umprogrammierbaren Speichers (10) mit Speichertransistoren (11) aufweisenden Speicherzellen (20 bis 43), dadurch gekennzeichnet, dass für die Funktionsprüfung die durch die Einsatzspannungsdifferenz zwischen gelöschtem und geschriebenem Zustand gegebene Breite der Lesefenster der Speichertransistoren (11) im Vergleich zum Normalbetrieb reduziert wird.

2. Verfahren nach Anspruch 1, dadurch gekennzeichnet, dass die Breite der Lesefenster um mindestens 50%, insbesondere mindestens 80% reduziert wird.

3. Verfahren nach Anspruch 1 oder 2, dadurch gekennzeichnet, dass die Breite der Lesefenster durch eine Zeitregelung des Lösch- und Schreibablaufes reduziert wird.

4. Verfahren nach einem der Ansprüche 1 bis 3, dadurch gekennzeichnet, dass die Ansteuerschaltung (52) für Löschen und Schreiben der Speicherzellen (20 bis 43) des Speichers (10) mit unterschiedlicher Lösch- bzw. Schreibdauer betrieben wird und dass das Ende der Lösch- bzw. Schreibdauer durch die Kontrolle des Erreichens eines vorgegebenen Lösch- bzw. Schreibzustandes mindestens einer Speicherzelle (11) des Speichers festlegbar ist.

5. Verfahren nach einem der Ansprüche 1 bis 4, dadurch gekennzeichnet, dass das Erreichen des vorgegebenen Löschzustandes durch Vergleich der Schwellspannung ($U_T$) des Speichertransistors (11) mit einer vorgegebenen Löschkontrollspannung ($U_{GLK}$) festgelegt wird.

6. Verfahren nach einem der Ansprüche 1 bis 5, dadurch gekennzeichnet, dass das Erreichen des vorgegebenen Schreibzustandes durch Vergleich der Schwellspannung ($U_T$) des Speichertransistors (11) mit einer vorgegebenen Schreibkontrollspannung ($U_{GSK}$) ermittelt wird.

7. Verfahren nach einem der Ansprüche 1 bis 6, dadurch gekennzeichnet, dass die Reduzierung des Lesefensters für die Funktionsprüfung durch Veränderung der am Steuergate der Speichertransistoren (11) anlegbaren Lösch- und Schreibkontrollspannungen eingestellt wird.

8. Verfahren nach einem der Ansprüche 1 bis 7, dadurch gekennzeichnet, dass die Verschiebung der Schwellenspannung der Speichertransistoren beim Umprogrammieren in einer Richtung gleichzeitig für alle Speicheradressen und in der anderen Richtung zeitlich nacheinander, insbesondere wortweise, erfolgt.

9. Verfahren nach einem der Ansprüche 1 bis 7, dadurch gekennzeichnet, dass die Verschiebung der Schwellenspannung der Speichertransistoren beim Umprogrammieren für alle Speicheradressen gleichzeitig erfolgt.

10. Verfahren nach einem der Ansprüche 1 bis 7, dadurch gekennzeichnet, dass die Verschiebung der Schwellenspannung der Speichertransistoren beim Löschen und Schreiben wortseriell erfolgt.

11. Anordnung zur Durchführung des Verfahrens nach einem der Ansprüche 1 bis 10, dadurch gekennzeichnet, dass eine Ansteuerschaltung vorgesehen ist, die für Löschen und Schreiben mit für jede Speicherzelle (20 bis 43) variabler Lösch- bzw. Schreibdauer (L', S') arbeitet und die das Ende der Lösch- bzw. Schreibdauer (L', S') durch Kontrolle des Erreichens eines vorgegebenen Lösch- bzw. Schreibzustandes mindestens einer Speicherzelle (11) aus der zu löschenden bzw. zu schreibenden Speicherzeile (Z1) festlegt.

## Claims

1. A method for the functional testing of an electrically word reprogrammable store (10) comprising storage cells (20 to 43) provided with storage transistors (11), characterised in that, for the functional testing, the width of the read windows of the storage transistors (11), which is determined by the threshold voltage difference between the erased state and the written state, is reduced in comparison to normal operation.

2. A method as claimed in Claim 1, characterised in that the width of the read windows is reduced by at least 50%, in particular at least 80%.

3. A method as claimed in Claim 1 or 2, characterised in that the width of the read windows is reduced by a time regulation of the erase and write operations.

4. A method as claimed in one of Claims 1 to 3, characterised in that the drive circuit (52) for erasing and writing the storage cells (20 to 43) of the store (10) is operated with different erase and write times, and that the end of the erase and/or write time can be determined by the monitoring of the reaching of a predetermined erase or write state of at least one storage cell (11) of the store.

5. A method as claimed in one of Claims 1 to 4, characterised in that the reaching of the predetermined erase state is determined by comparing the threshold voltage ($U_T$) of the storage transistor (11) with a predetermined erase monitoring voltage ($U_{GLK}$).

6. A method as claimed in one of Claims 1 to 5, characterised in that the reaching of the predetermined write state is determined by comparing the threshold voltage ($U_T$) of the storage transistor (11) with a predetermined write monitoring voltage ($U_{GSK}$).

7. A method as claimed in one of Claims 1 to 6, characterised in that the reduction of the read window for the functional testing is set by changing the erase and write monitoring voltages which can be connected to the control gate of the storage transistors (11).

8. A method as claimed in one of Claims 1 to 7, characterised in that the displacement of the threshold voltage of the storage transistors in the case of reprogramming takes place simultaneously for all the store addresses in one direction, and takes place consecutively, in particular word-by-word, in the other direction.

9. A method as claimed in one of Claims 1 to 7, characterised in that the displacement of the threshold voltage of the storage transistors in the case of reprogramming takes place simultaneously for all the stored store addresses.

10. A method as claimed in one of Claims 1 to 7, characterised in that the displacement of the threshold voltage of the storage transistors in the case of the erase operation and write operation takes place in word-serial fashion.

11. An arrangement for executing the method claimed in one of Claims 1 to 10, characterised in that a drive circuit is provided which, for the erase operation and write operation, operates with erase and write times (L', S') variable for each storage cell (20 to 43), and determines the end of the erase and/or write time (L', S') by monitoring the reaching of a predetermined erase and/or write state of at least one storage cell (11) from the storage row (Z1) which is to be erased or written.

## Revendications

1. Procédé pour contrôler le fonctionnement d'une mémoire (10) électriquement reprogrammable par mots, comportant des cellules de mémoire (20 à 43) possédant des transistors de mémoire (11), caractérisé par le fait que pour le contrôle de fonctionnement, on réduit la largeur, déterminée par la différence des tensions de déclenchement entre l'état effacé et l'état enregistré, de la fenêtre de lecture des transistors de mémoire (11), par rapport au fonctionnement normal.

2. Procédé suivant la revendication 1, caractérisé par le fait qu'on réduit la largeur de la fenêtre de lecture d'au moins 50% et notamment d'au moins de 80%.

3. Procédé suivant la revendication 1 ou 2, caractérisé par le fait qu'on réduit la largeur de la fenêtre de lecture au moyen d'une régulation temporelle du cycle d'effacement et de lecture.

4. Procédé suivant l'une des revendications 1 à 3, caractérisé par le fait que le circuit de commande (52) utilisé pour l'effacement des cellules (20 à 43) de la mémoire (10) fonctionne avec une durée différente d'effacement ou d'enregistrement et que la fin de la durée d'effacement ou d'enregistrement peut être déterminée au moyen du contrôle du fait qu'au moins une cellule (11) de la mémoire a atteint un état prédéterminé d'effacement ou d'enregistrement.

5. Procédé suivant l'une des revendications 1 à 4, caractérisé par le fait que l'obtention de l'état prédéterminé d'effacement est déterminé par comparaison de la tension de seuil ($U_T$) du transistor de mémoire (11) avec une tension prédéterminée de commande d'effacement ($U_{GLK}$).

6. Procédé suivant l'une des revendications 1 à 5, caractérisé par le fait que l'obtention de l'état prédéterminé d'enregistrement est déterminée par comparaison de la valeur de seuil ($U_T$) du transistor de mémoire (11) avec une tension prédéterminée de commande d'enregistrement ($U_{GSK}$).

7. Procédé suivant l'une des revendications 1 à 6, caractérisé par le fait qu'on règle la réduction de la fenêtre de lecture pour le contrôle de fonctionnement en modifiant les tensions de commande d'effacement et d'enregistrement pouvant être appliquées à la porte de commande des transistors de mémoire (11).

8. Procédé suivant l'une des revendications 1 à 7, caractérisé par le fait que lors de la reprogrammation, le décalage de la tension de seuil des transistors de mémoire s'effectue simultanément dans un sens pour toutes les adresses de mémoire et successivement dans l'autre sens, notamment par mots.

9. Procédé suivant l'une des revendications 1 à 7, caractérisé par le fait que lors de la reprogrammation, le décalage de la tension de seuil du transistor de mémoire est réalisé simultanément pour toutes les adresses de mémoire.

10. Procédé suivant l'une des revendications 1 à 7, caractérisé par le fait que lors de l'effacement et de l'enregistrement le décalage de la tension de seuil des transistors de mémoire s'effectue en série par mots.

11. Dispositif pour la mise en œuvre du procédé suivant l'une des revendications 1 à 10, caractérisé par le fait qu'il est prévu un circuit de commande qui travaille, pour l'effacement et l'enregistrement, avec une durée d'effacement ou d'enregistrement (L', S') variable pour chaque cellule de mémoire (20 à 43) et détermine la fin de la durée d'effacement ou d'enregistrement (L', S') au moyen du contrôle du fait qu'au moins une cellule de mémoire (11) de la ligne de mémoire (Z1), dans laquelle un effacement ou un enregistrement doit être exécuté, a atteint un état prédéterminé d'effacement ou d'enregistrement.

# FIG 1

0 086 361

# FIG 2

# FIG 3